Europäisches Patentamt

European Patent Office

Office européen des brevets

(19)

(11) Numéro de publication : **0 331 546 B1**

(12) **FASCICULE DE BREVET EUROPEEN**

(45) Date de publication du fascicule du brevet :
05.08.92 Bulletin 92/32

(51) Int. Cl.⁵ : **H04N 3/15, H01L 27/14**

(21) Numéro de dépôt : **89400373.0**

(22) Date de dépôt : **09.02.89**

(54) **Matrice photosensible à deux diodes par point, sans conducteur spécifique de remise à niveau.**

(30) Priorité : **26.02.88 FR 8802360**

(43) Date de publication de la demande :
**06.09.89 Bulletin 89/36**

(45) Mention de la délivrance du brevet :
**05.08.92 Bulletin 92/32**

(84) Etats contractants désignés :
**DE FR GB NL**

(56) Documents cités :
**FR-A- 2 593 987**

(73) Titulaire : **THOMSON-CSF**
**51, Esplanade du Général de Gaulle**
**F-92800 Puteaux (FR)**

(72) Inventeur : **Berger, Jean-Luc**
**THOMSON-CSF SCPI 19, avenue de Messine**
**F-75008 Paris (FR)**
Inventeur : **Arques, Marc**
**THOMSON-CSF SCPI 19, avenue de Messine**
**F-75008 Paris (FR)**

(74) Mandataire : **Guérin, Michel et al**
**THOMSON-CSF SCPI**
**F-92045 PARIS LA DEFENSE CEDEX 67 (FR)**

EP 0 331 546 B1

## Description

L'invention concerne les matrices d'éléments photosensibles.

Pour réaliser des matrices d'éléments photosensibles, il est classique de prévoir un réseau de conducteurs en ligne, et un réseau de conducteurs en colonne, avec, à chaque croisement d'une ligne et d'une colonne, un élément photosensible respectif. Par le réseau de lignes on sélectionne une ligne d'éléments photosensibles dont on veut connaître les signaux électriques de sortie; par le réseau de conducteurs de colonnes, on lit un signal de sortie respectif pour chacun des éléments de la ligne sélectionnée.

Dans la demande de brevet français FR-A-2593343, on a décrit une matrice photosensible comportant un réseau de points photosensibles dans lequel chaque point photosensible comprend une capacité de stockage de charges en série avec un élément photosensible, l'ensemble étant connecté entre un conducteur de ligne et un conducteur de colonne; l'élément photosensible peut être une photodiode PIN à trois couches (couche semiconductrice de type P, couche intrinsèque I, couche de type N).

Des charges sont engendrées dans la photodiode par l'éclairement du point photosensible. Elles s'accumulent sur le noeud (flottant) entre la photodiode et la capacité. Elles sont lues par application au conducteur de ligne d'une impulsion de tension dans un sens qui polarise la photodiode en direct (alors qu'elle était polarisée en inverse pendant la phase d'accumulation). Des charges en quantité correspondant aux charges accumulées sont alors transférées du noeud flottant vers la colonne (ou inversement de la colonne vers le noeud flottant); la lecture consiste à mesurer ce mouvement de charges.

Après la fin de l'impulsion de lecture, la photodiode se bloque pour une nouvelle phase d'éclairement et d'intégration de charges.

Mais le potentiel du noeud flottant n'est plus à la valeur qu'il avait au début de la phase d'intégration; on ne peut donc pas commencer une nouvelle phase d'intégration sans établir à une valeur de départ bien déterminée ce potentiel du noeud flottant.

La phase de lecture est donc suivie d'une phase de remise à niveau du potentiel du noeud flottant.

La remise à niveau se fait par éclairement de la photodiode. Il est donc nécessaire de prévoir une source d'éclairement et des moyens de commande synchronisés avec les moyens de lecture de la matrice photosensible pour effectuer une remise à niveau après chaque phase de lecture.

A cause de cela, il est nécessaire que l'acquisition d'un signal de mesure d'éclairement se fasse de manière discontinue: éclairement, puis lecture, puis flash de remise à niveau, puis nouvel éclairement, etc.

La présente invention propose une nouvelle structure de point photosensible qui élimine la nécessité d'une source d'éclairement de remise à niveau et qui permet d'acquérir l'information en flux continu sans qu'il soit nécessaire d'éclairer la matrice de manière discontinue.

Selon l'invention, on propose une matrice de points photosensibles comportant un réseau de points photosensibles agencés en lignes (au moins une ligne) et en colonnes (au moins une colonne), chaque point photosensible étant situé au carrefour d'une ligne et d'une colonne, caractérisée en ce que chaque point photosensible comprend un élément photosensible en série avec une diode de lecture entre un conducteur de ligne et un conducteur de colonne, la diode de lecture présentant un premier seuil de tension de mise en conduction dans le sens direct, et un deuxième seuil de tension pour la mise en conduction dans le sens inverse, la matrice comportant en outre, pour la lecture des charges accumulées au point de jonction de l'élément photosensible et de la diode de lecture, un moyen pour appliquer sur le conducteur de ligne:

– d'abord un niveau de tension de repos sur le conducteur de ligne pendant une phase d'intégration de charges;
– puis une impulsion de tension d'un premier signe, dite impulsion de lecture;
– enfin une impulsion de tension du signe opposé, dite impulsion de remise à niveau, l'amplitude de la différence entre les niveaux de tension de l'impulsion de lecture et de l'impulsion de remise à niveau étant supérieure en valeur absolue à l'écart entre les seuils de mise en conduction directe et inverse de la diode de lecture.

L'élément photosensible peut-être une photodiode ou un photoconducteur.

La diode de lecture est conçue pour avoir une capacité beaucoup plus faible que l'élément photosensible; elle aura en général pour cette raison une surface beaucoup plus faible que la surface de l'élément photosensible.

Le choix de l'amplitude de l'impulsion de remise à niveau est fait de telle sorte que le potentiel du noeud commun reliant l'élément photosensible à la diode de lecture revienne toujours à la même valeur après une impulsion de remise à niveau, et c'est pourquoi on impose une relation entre l'amplitude de l'impulsion et l'écart entre les seuils de mise en conduction de la diode de lecture dans les sens direct et inverse. De préférence, l'amplitude de la différence entre le niveau de tension de repos et le niveau de tension de l'impulsion de remise à niveau est très voisine de l'écart entre les seuils de tension de mise en conduction directe et inverse de la diode de lecture.

La diode de lecture aura une caractéristique tension/courant ressemblant à celle d'une diode zener, avec un seuil de tension de mise en conduction inverse relativement faible en valeur absolue (entre - 8 et - 10 volts par exemple) et un seuil de mise en conduction directe de l'ordre de + 1 volt.

La diode de lecture est appelée ici "diode" car elle a une caractéristique courant tension semblable à celle d'une diode, mais elle peut être réalisée sous forme d'une structure qui n'est pas nécessairement celle d'une diode PN au sens classique. En particulier, la diode de lecture peut avantageusement être réalisée sous forme d'un transistor à base ouverte de type NIPIN, c'est-à-dire une structure à deux électrodes et à cinq couches semiconductrices superposées qui sont respectivement une couche dopée de type N, une couche intrinsèque relativement épaisse, une couche très mince de type P, une couche très mince intrinsèque, et enfin une couche dopée de type N. Un transistor PINIP (tous les types de conductivité sont inversés par rapport au transistor NIPIN) peut être utilisé aussi.

Avec ce type de diode de lecture, on obtient une valeur assez reproductible des tensions de seuil de mise en conduction directe et inverse, ce qui est souhaitable; ces tensions ont par ailleurs des valeurs tout à fait compatibles avec les valeurs d'impulsions qu'on peut appliquer sur les conducteurs de ligne par l'intermédiaire de circuits de commande à transistors MOS.

On verra dans la description détaillée qui suit que deux possibilités de fonctionnement différentes existent selon que la tension de repos du conducteur de ligne est supérieure ou inférieure au seuil de tension de mise en conduction inverse de la diode de lecture. Dans l'une des possibilités, on obtient l'avantage que la quantité de charges lues est toujours supérieure à un seuil déterminé, même pour un éclairement maximal correspondant à la saturation du point photosensible, et ceci facilite la lecture des charges; on obtient aussi une plus grande dynamique de mesure de charges entre un éclairement minimal et un éclairement de saturation. Dans l'autre cas, l'excursion de tension est inférieure mais on obtient l'avantage qu'en cas de saturation, les charges en excès engendrées par un éclairement trop fort sont évacuées vers un conducteur de ligne et non pas un conducteur de colonne; les charges en excès provenant de points d'une ligne qu'on n'est pas en train de lire ne viennent donc pas perturber, sur une colonne, les charges qu'on est en train de lire et qui proviennent d'une autre ligne de points.

L'invention est applicable à toutes sortes de matrices photosensibles, y compris celles qui sont utilisées en radiologie et qui comportent de ce fait un scintillateur (oxyde de gadolinium, iodure de césium, etc.) pour convertir un rayonnement X (ou gamma, ou neutronique, etc.) en rayonnemnt lumineux dans la bande de longueurs d'onde auxquelles les photodiodes sont sensibles.

L'invention se prête particulièrement à une réalisation dans laquelle les points photosensibles sont constitués par superposition de couches de silicium amorphe.

Parmi les avantages que l'on escompte de la présente invention, car ils sont essentiels pour la qualité des matrices réalisées, on peut mentionner:
- la simplicité de la structure dans laquelle chaque point photosensible ne comporte que deux éléments,
- la faible capacité des colonnes de points photosensibles,
- la rapidité de la lecture,
- le bon découplage entre les points photosensibles de lignes ou colonnes voisines,
- la réduction de bruit parasite au moment de la lecture, bruit qui pouvait être généré dans les systèmes antérieurs par la mise en conduction directe de la diode photosensible; ici, la photodiode reste en principe toujours polarisée en inverse, même pendant la lecture.

D'autres caractéristiques et avantages de l'invention apparaîtront à la lecture de la description détaillée qui suit et qui est faite en référence aux dessins annexés dans lesquels:
- la figure 1 représente une matrice de points photosensibles selon l'invention;
- la figure 2 représente une courbe tension/courant d'une diode de lecture d'une matrice selon l'invention;
- la figure 3 représente schématiquement une diode de lecture constituée par une structure à cinq couches entre deux électrodes;
- la figure 4 représente le diagramme temporel des potentiels du conducteur de ligne Li et du noeud A de la matrice de la figure 1, dans un premier mode de fonctionnement de cette matrice;
- la figure 5 représente le diagramme temporel des potentiels du conducteur de ligne Li et du noeud A de la matrice de la figure 1, dans un deuxième mode de fonctionnement de cette matrice.

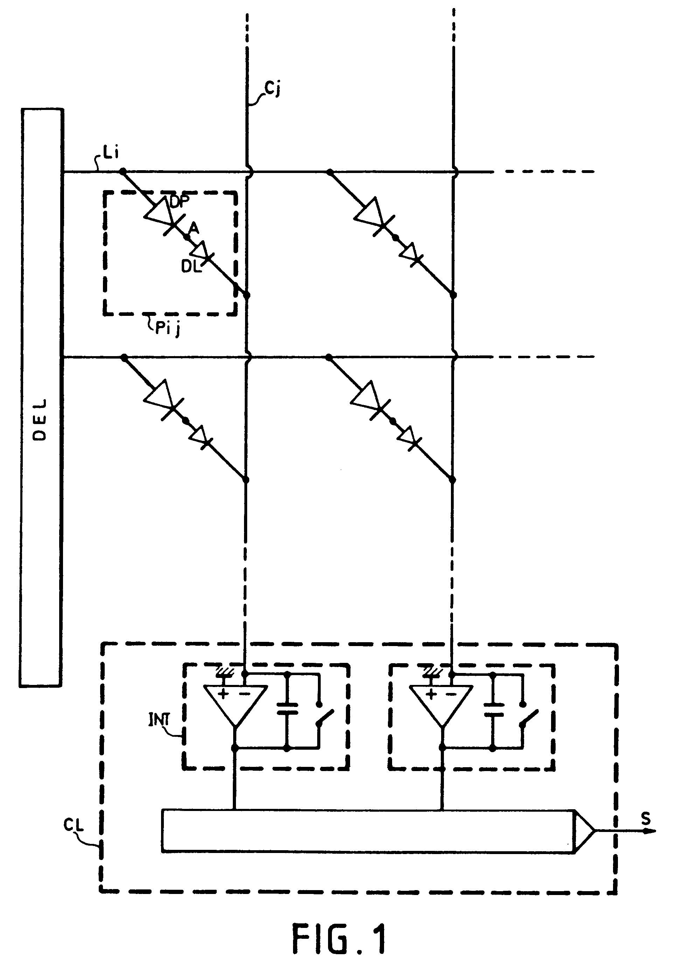

Sur la figure 1, on voit un schéma simplifié d'une matrice de points photosensibles selon la présente invention.

La matrice comprend un réseau de lignes et de colonnes de points photosensibles Pij.

Chaque ligne comprend un conducteur de ligne Li auquel sont raccordés les points photosensibles de cette ligne; le conducteur de ligne Li sert à fournir une tension de repos Vp pendant une phase d'intégration, puis une impulsion de lecture pendant une phase de lecture, et enfin une impulsion de remise à niveau pendant une phase de remise à niveau avant une nouvelle phase d'intégration. Les conducteurs de ligne sont connectés à un décodeur de ligne DEL apte à sélectionner une ligne déterminée dont on veut lire les points et à fournir les impulsions de lecture et remise à niveau sur cette ligne sélectionnée pendant que les autres lignes sont maintenues à la tension de repos Vp.

Chaque colonne comprend un conducteur de colonne Cj auquel sont raccordés les points photosensibles de cette colonne; le conducteur de colonne Cj est relié à un circuit CL de lecture des charges générées par le point photosensible Pij situé à l'intersection de cette colonne et de la ligne sélectionnée.

Dans un exemple de réalisation, le circuit de lecture comprend un intégrateur INT pour chacune des colonnes de points, et un multiplexeur MUX recevant les sorties des intégrateurs pour fournir sur sa sortie S successivement des signaux représentant l'éclairement des points successifs de la ligne désignée.

Dans d'autres cas, le circuit de lecture pourrait être un circuit à transfert de charges et le multiplexeur pourrait être un registe à décalage à transfert de charges.

Selon l'invention, chaque point photosensible Pij comprend un élément photosensible DP qui est en principe une photodiode mais qui peut être autre chose, par exemple un photoconducteur. Cet élément est connecté en série avec une diode de lecture DL, et l'ensemble est relié entre une ligne Li et une colonne Cj. Dans ce qui suit, on considèrera que l'élément photosensible est une photodiode DP.

Le point de jonction A entre l'élément photosensible et la diode de lecture est le noeud où s'accumulent les charges électriques engendrées par l'éclairement dans l'élément photosensible.

La diode de lecture DL, qui permet le transfert de charges du noeud flottant A vers le conducteur de colonne Cj, possède des caractéristiques particulières selon l'invention.

Tout d'abord, elle doit avoir une capacité faible devant celle de la photodiode, ce qui permet que la capacité globale vue d'une colonne soit nettement inférieure à la somme des capacités des photodiodes connectées à cette colonne.

Ensuite, selon l'invention, on prévoit que la diode de lecture peut être mise en conduction directe si la tension à ses bornes devient supérieure à un premier seuil de tension Vsd, et qu'elle peut être mise en conduction inverse si la tension à ses bornes devient inférieure à un deuxième seuil de tension Vsi.

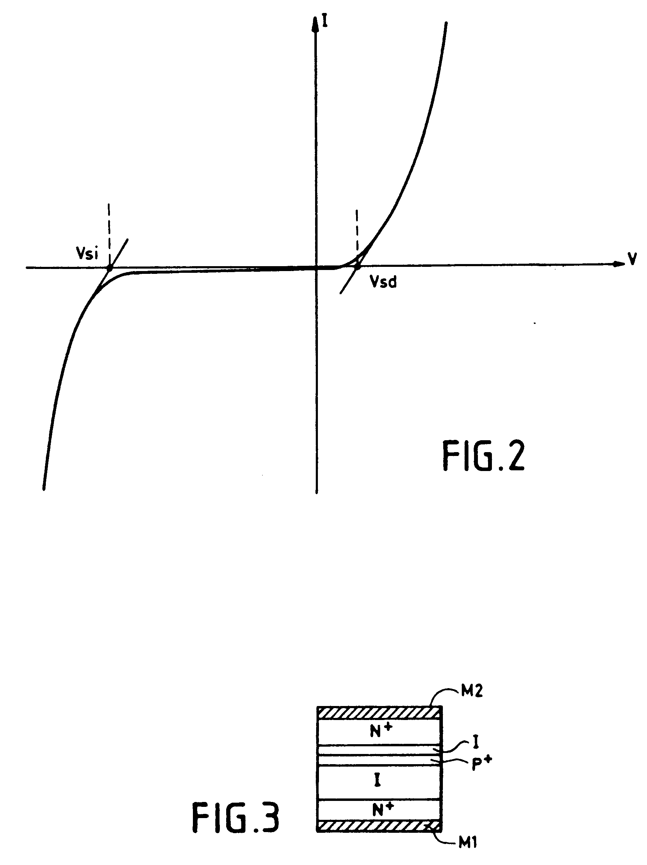

En d'autres mots, la diode de lecture a une caractéristique courant/tension du genre représenté sur la figure 2, analogue à celle d'une diode zener.

Les seuils de tension doivent être compatibles avec le fonctionnement des circuits de commande de la matrice. Si la matrice doit fonctionner avec des transistors MOS par exemple, il est souhaitable que les seuils de mise en conduction n'aillent pas en valeur absolue au delà de 12 à 15 volts.

Mais d'autre part, l'écart entre le premier seuil et le deuxième seuil doit être suffisamment important car c'est lui qui limitera la dynamique du signal de mesure de l'éclairement.

A titre d'exemple, on sait réaliser des diodes dont la mise en conduction directe a lieu pour un premier seuil de tension positif d'environ + 1volt et dont la mise en conduction inverse a lieu pour un second seuil de tension négatif ajustable entre environ - 8 à - 15 volts par un choix approprié de dopages de couches semiconductrices.

Etant donné qu'il est extrêmement souhaitable que ces seuils soient stables et reproductibles, on choisira de réaliser la diode de lecture DL selon une technologie qui permette d'obtenir cette stabilité et cette reproductibilité. On a remarqué qu'une diode dont la conduction inverse se fait par mise en avalanche d'une jonction n'offre pas toutes les garanties de stabilité et reproductibilité souhaitables; mais un transistor à base ouverte de type NIPIN dont la conduction inverse se fait par abaissement d'une barrière de potentiel, peut servir de diode de lecture ayant de bien meilleures caractéristiques de ce point de vue.

Un transistor NIPIN est une structure à cinq couches semiconductrices superposées entre deux électrodes M1 et M2, telle que schématisée à la figure 3; cette structure est facilement réalisable en silicium amorphe, par dépot successif d'une couche de silicium de type N, d'une couche de silicium intrinsèque relativement épaisse, d'une couche très mince de type P, d'une couche très mince intrinsèque, et d'une couche de type N. Le côté du transistor qui est raccordé au conducteur de colonne est le collecteur (du côté de la couche intrinsèque la plus épaisse) si la photodiode DP a sa cathode reliée au point A, et l'autre côté dans le cas contraire.

La photodiode peut être une diode PIN. Elle peut être aussi un phototransistor à base ouverte de type NIPIN. A la limite, elle pourrait être remplacée par un simple photoconducteur tel qu'une couche intrinsèque de silicium amorphe.

La photodiode DP est de surface relativement importante pour que sa sensibilité soit suffisante; la diode de lecture DL est plus petite et est de préférence mise dans l'obscurité, par exemple grâce à une couche métallique qui la recouvre.

On va maintenant décrire le fonctionnement de la matrice de la figure 1 d'abord dans un cas où la tension de repos Vp appliquée au conducteur de ligne pendant l'accumulation de charges photoélectriques est supérieure au seuil Vsi de mise en conduction inverse de la diode de lecture, puis dans un cas où la tension de repos est inférieure à ce seuil, et on montrera comment le choix des potentiels appliqués aux conducteurs de ligne doit être lié aux seuils de mise en conduction directe (Vsd) et inverse (Vsi) de la diode de lecture ou de la structure qui en tient lieu.

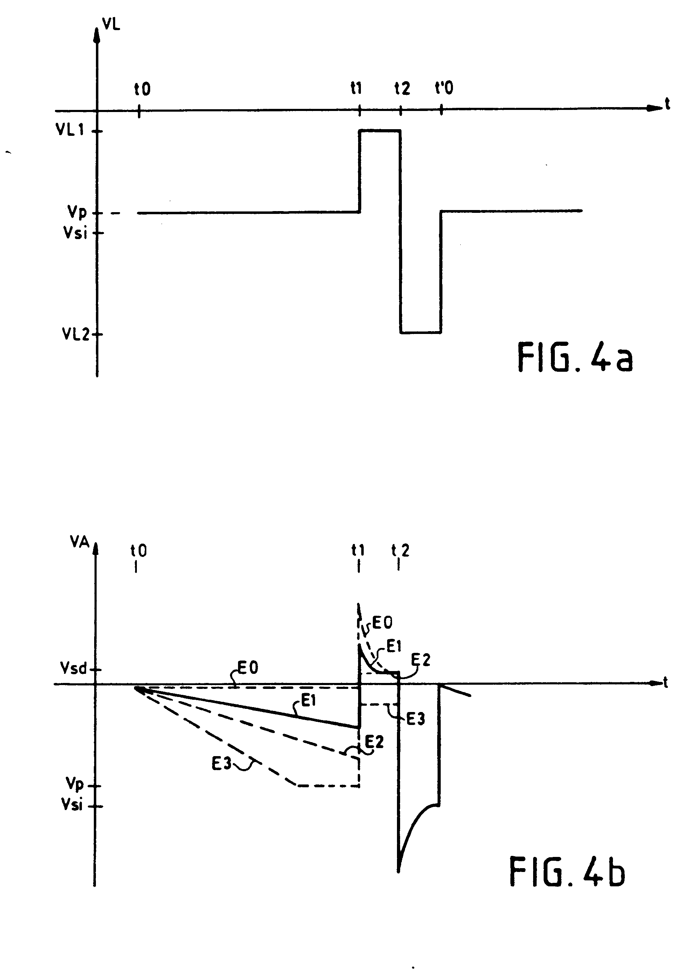

I. CAS OU Vp EST SUPERIEUR A Vsi : Figure 4

Pour simplifier les explications, on supposera que la capacité de la diode de lecture est négligeable devant celle de la diode photosensible DP; s'il n'en était pas ainsi, les valeurs numériques de potentiels et de variations de potentiel indiquées au cours des explications seraient modifiées, mais le principe de fonctionnement resterait valable.

On supposera aussi que le circuit de lecture connecté aux colonnes maintient le potentiel de celles-ci à une valeur de référence nulle.

La figure 4 représente des diagrammes temporels permettant d'illustrer le fonctionnement. Les variations du potentiel VL appliqué au conducteur de ligne Li sont représentées sur le diagramme 4a; les variations du potentiel VA du noeud A sont représentées sur le diagramme 4b.

Le cycle de fonctionnement périodique dure entre un instant t0 et un instant t'0.

Au départ, juste après l'instant t0, c'est-à-dire juste après qu'on ait ramené le potentiel du conducteur de ligne d'une ligne sélectionnée à sa valeur de repos Vp, l'état initial est le suivant:

— le potentiel VL sur le conducteur de ligne Li a une valeur de repos Vp, par exemple -5 volts; la valeur est choisie de telle manière que la photodiode reste polarisée en inverse même quand le potentiel du noeud A va descendre par suite de l'arrivée de photocharges;

— le potentiel VA sur le noeud A a une valeur nulle ou proche de zéro.

— le potentiel du conducteur de colonne Cj est supposé nul.

On verra que c'est bien la situation qui va exister à la fin du cycle de lecture qu'on va maintenant décrire.

Au temps t0 commence une phase d'intégration de charges qui va durer jusqu'au temps t1.

L'éclairement engendre des charges, qui viennent s'accumuler sur le noeud A sous l'influence du champ électrique dans la photodiode DP polarisée en inverse. Avec les sens de potentiel choisis, compte tenu du sens de connexion de la photodiode, les charges qui s'accumulent sont des électrons.

Le potentiel du noeud A s'abaisse au fur et à mesure de l'arrivée des charges, donc avec une pente de décroissance proportionnelle à l'intensité de l'éclairement.

On a représenté sur le diagramme 4b quatre cas d'éclairement différents:

— éclairement E0 nul ou quasinul;

— éclairement moyen E1;

— éclairement maximal mesurable E2;

— éclairement fort engendrant un effet de déversement de charges en excès dans le conducteur de ligne, réalisant ainsi un effet d'antiéblouissement.

Au temps t1 se termine la période d'intégration et une impulsion de lecture est appliquée au conducteur de ligne sélectionné, faisant passer son potentiel d'une valeur de repos Vp à une valeur VL1.

La valeur VL1 est choisie négative pour ne pas mettre en conduction directe la photodiode, mais suffisamment proche de zéro pour que la dynamique de mesure d'éclairement soit suffisamment élevée. Cette dynamique est en effet liée à la différence de potentiel entre VL1 et Vp et cette différence doit être suffisante.

Dans l'exemple choisi, on a pris VL1 égale à - 1 volt.

Par couplage capacitif, l'accroissement brusque de tension sur le conducteur de ligne se transmet au noeud A; la photodiode DP est en effet polarisée en inverse et comme sa capacité est beaucoup plus élevée que celle de la diode de lecture, on retrouve au noeud A l'essentiel de l'amplitude du front de montée de l'impulsion de lecture.

Le potentiel du noeud A, qui avait une valeur d'autant plus basse que l'éclairement avait été plus fort pendant la phase d'intégration, augmente brusquement d'une valeur (VL1 - Vp).

Les quatre cas d'éclairement représentés à la figure 4 engendrent les effets suivants:

— éclairement minimal E0 : le potentiel du noeud A passe pratiquement de 0 à VL1 - Vp. La diode de lecture devient conductrice et le potentiel du noeud A est ramené à la valeur Vsd (seuil de conduction directe de la diode). Une quantité de charges est transmise au conducteur de colonne Cj pour ramener le potentiel du noeud A à la valeur Vsd. C'est cette quantité de charges qui est lue par le circuit de lecture et qui représente l'éclairement nul auquel a été soumise la photodiode pendant la phase d'intégration t0,t1;

— éclairement moyen E1 : le potentiel du noeud A était au dessous de zéro et passe au dessus de Vsd au temps t1. La diode de lecture devient conductrice et une quantité de charges est évacuée vers le conducteur de colonne; cette quantité est plus faible que dans le cas précédent car le potentiel du noeud A est monté moins haut; elle représente encore une mesure de l'éclairement auquel a été soumise la photodiode de t0 à t1;

— éclairement de saturation E2 : le potentiel du noeud A était descendu à une valeur telle que lorsqu'on applique l'impulsion de lecture d'amplitude VL1 - Vp, ce potentiel ne monte qu'à la valeur Vsd. La diode de lecture n'est pratiquement pas rendue conductrice, ou elle se rebloque sans transférer de charge. Une charge nulle est lue sur le conducteur de colonne; cette charge nulle représente un éclairement de saturation;

— éclairement au delà de E2 : le potentiel du noeud A ne monte jamais assez au moment de l'impulsion de lecture pour rendre conductrice la diode de lecture; on lit toujours une charge nulle.

— éclairement E3 : le potentiel du noeud A ne peut pas descendre pendant la phase d'intégration au dessous du potentiel Vp; si des charges photoélectriques continuent d'être engendrées, alors que le potentiel du noeud A a déjà atteint la valeur Vp, elles sont évacuées à travers la photodiode vers le conducteur de ligne. En outre, comme pour le cas précédent, la charge lue sur la colonne pendant l'impulsion de lecture est nulle.

On aboutit donc à un transfert de charges sur la colonne d'autant plus faible que l'éclairement est plus important, ce qui peut être avantageux pour la lecture des faibles éclairements. De plus, il y a un effet de saturation, et un effet d'antiéblouissement par évacuation de charges en excès. Le seuil de saturation n'est d'ailleurs pas le même que le seuil d'antiéblouissement.

L'impulsion de lecture dure suffisamment longtemps pour que la totalité des charges présentes sur le noeud A ait le temps de s'évacuer. Elle se termine au temps t2.

Au temps t2, l'impulsion de remise à niveau est appliquée. On pourrait toutefois prévoir un intervalle de temps de séparation entre la fin de l'impulsion d lecture et le début de l'impulsion de remise à niveau, le potentiel VL du conducteur de ligne revenant provisoirement à sa valeur de repos pendant cet intervalle.

L'impulsion de remise à niveau consiste à faire passer le potentiel VL du conducteur de ligne à une valeur VL2 telle que le potentiel du noeud A descende, par couplage capacitif, à une valeur inférieure au seuil Vsi de mise en conduction inverse de la diode de lecture.

Là encore, comme la photodiode présente une capacité beaucoup plus grande que la capacité de la diode de lecture, la variation de potentiel VL2 -VL1 est retransmise pratiquement intégralement au noeud A.

Dans l'exemple choisi, on fait passer le potentiel de VL1 = - 1 volt à VL2 = - 11 volts.

Il est indispensable que VL1 - VL2 soit supérieur à l'écart Vsd - Vsi entre les seuils de conduction directe et inverse de la diode pour que le potentiel du noeud A passe de la valeur Vsd à une valeur inférieure à Vsi.

La diode de lecture devient alors conductrice (mais en polarisation inverse) et le potentiel du noeud A revient rapidement à la valeur Vsi pour laquelle la diode cesse d'être conductrice. L'impulsion de remise à niveau doit durer un temps suffisant pour permettre ce retour du potentiel du noeud A à la valeur Vsi.

Le début d'une nouvelle phase d'intégration est défini par la fin (au temps t'0) de l'impulsion de remise à niveau. A cet instant on ramène à sa valeur de repos Vp le potentiel du conducteur de ligne.

L'écart de tension VL2 - Vp est choisi de préférence justement égal à Vsi pour que le potentiel du noeud A, qui s'accroît par couplage capacitif d'une valeur Vp - VL2 à l'instant t'0 revienne de la valeur Vsi à zéro. Le potentiel du noeud A revient donc à la valeur de départ qu'on avait envisagée au début de la phase d'intégration. Le cycle est terminé.

On pourrait cependant prévoir que l'écart de tension VL2 - Vp est choisi en valeur absolue légèrement plus petit que la valeur absolue de Vsi. Mais il vaut mieux que le potentiel du noeud A remonte aussi haut que possible vers le seuil Vsd pour bénéficier d'une dynamique maximale de lecture. On peut aussi envisager que l'écart de tension VL2 - Vp soit choisi en valeur absolue supérieur à la valeur absolue de l'écart Vsd - Vsi; dans ce cas, la diode de lecture repasse à l'instant t'0 en conduction directe, et le potentiel du point A revient progressivement à la valeur Vsd (et non zéro) en évacuant des charges sur la colonne ; dans ce cas, chaque phase d'intégration recommence à partir d'un potentiel de départ Vsd sur le noeud A.

Selon l'invention, on choisit donc les potentiels VL1, VL2, et Vp de manière que
- d'une part VL1-VL2 soit supérieur à Vsd-Vsi,
- d'autre part que VL2-Vp soit proche de Vsi.

## II. CAS OU Vp EST INFERIEUR A Vsi

Le fonctionnement est tout à fait analogue au cas précédent, avec une phase d'intégration (t0 à t1) suivie d'une impulsion de lecture (t1 à t2) puis d'une impulsion de remise à niveau (t2 à t'0).

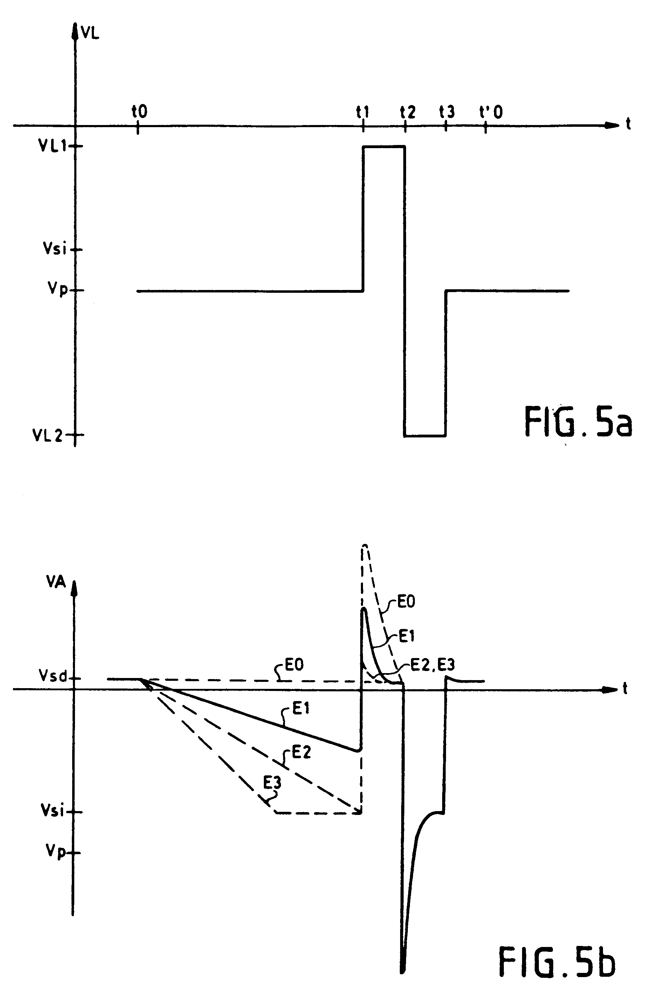

Les explications sont globalement les mêmes que celles qui ont été données précédemment et on se référera maintenant à la figure 5 pour voir les différences de fonctionnement.

Le diagramme temporel de la figure 5a représente les potentiels appliqués au conducteur de ligne durant le cycle d'intégration/lecture/remise à niveau. Le diagramme temporel de la figure 5b représente les niveaux de potentiel qui en résultent sur le noeud A.

Dans l'exemple représenté, on suppose que le point de départ du potentiel du noeud A au temps t0 est égal à Vsd, seuil de mise en conduction directe de la diode de lecture; mais on pourrait prévoir aussi que le potentiel de départ est zéro.

Pendant la phase d'intégration, le potentiel du conducteur de ligne est Vp, par exemple -8 volts, et le potentiel du noeud A descend de Vsd jusqu'à une valeur qui est fonction de l'éclairement. La courbe de variation du potentiel VA est représentée pour :
- un éclairement nul E0
- un éclairement moyen E1 (en traits pleins)
- un éclairement de saturation E2
- un éclairement E3 au delà du seuil de saturation.

Pour l'éclairement E2 et au delà, le potentiel du noeud A atteint la valeur Vsi au cours de la période d'intégration; mais il ne peut pas devenir plus négatif car alors la diode de lecture tend à devenir conductrice (en conduction inverse) et elle empêche les charges de continuer à s'accumuler sur le noeud A. Il y a saturation; les charges en excès s'écoulent sur la colonne Cj.

Au temps t1 est émise une impulsion de lecture : le potentiel du conducteur de ligne de la ligne à lire passe de Vp à VL1. VL1 est légèrement négative dans le cas où l'élément photodétecteur est une photodiode, car cette photodiode doit rester polarisée en inverse. Par exemple, VL1 = - 1 volt comme à la figure 4.

Le potentiel du noeud A monte brusquement d'une valeur VL1 - Vp. Comme il était compris entre Vsi et Vsd même pour un éclairement maximal, il passe de toutes façons au dessus de Vsd à condition que VL1 - Vp soit supérieur à Vsd - Vsi, ce qui est possible à condition de prendre VL1 suffisamment proche de Vsd. La différence de potentiel VL1 - Vp peut toutefois être légèrement inférieure à Vsd - Vsi, auquel cas, la saturation est plus progressive autour de l'éclairement E2.

La diode de lecture devient alors conductrice en conduction directe et évacue une quantité de charges qui est fonction de la valeur du potentiel du noeud A à l'instant t1.

On remarquera que la quantité de charges est d'autant plus grande que l'éclairement a été plus faible, ce qui facilite la lecture des faibles éclairements.

Au temps t2, c'est-à-dire après un temps suffisant pour que les charges aient eu le temps de s'évacuer vers la colonne, on applique sur le conducteur de ligne l'impulsion de remise à niveau : on fait passer le potentiel VL de la valeur VL1 à une valeur VL2 très inférieure à VL1, avec pour le choix de VL2 les critères suivants :

– l'intervalle VL1 - VL2 est supérieur à l'intervalle Vsd - Vsi, de façon que le potentiel du noeud A descende au dessous de Vsi à l'instant t2;

– et l'intervalle Vp - VL2 est égal à, ou très proche de, Vsd - Vsi, de façon qu'au temps t3 où se termine l'impulsion de remise à niveau, le potentiel du noeud A repasse brusquement de la valeur Vsi à la valeur Vd ou à une valeur très proche.

Au temps t2 par conséquent le potentiel du noeud A passe brusquement au dessous de Vsi, la diode de lecture devient conductrice en conduction inverse, et le potentiel du noeud A revient à la valeur Vsi.

Au temps t3, l'impulsion de remise à niveau se termine du fait qu'on remet le conducteur de ligne au potentiel Vp. Le potentiel VA remonte brusquement de la valeur Vsi à une valeur Vsi + (Vp - VL2), c'est-à-dire à une valeur qui est égale à, ou très proche de, Vsd.

Si le potentiel VA passe à Vsd, un nouveau cycle d'intégration peut recommencer immédiatement; s'il passe légèrement au dessus, la diode de lecture devient conductrice et évacue des charges sur la colonne et il faut compter que le nouveau cycle d'intégration démarre seulement au temps t'0, c'est-à-dire un bref instant après le temps t3, pour que le potentiel VA ait le temps de revenir à la valeur Vsd.

Si le potentiel VA revient légèrement au dessous de Vsd parce que Vp - VL2 est légèrement plus faible que Vsd - Vsi, alors c'est la valeur à laquelle revient le potentiel VA qui définit le nouveau point de départ de l'intégration. Le système peut fonctionner dans les trois cas.

Le fonctionnement du cycle d'intégration de charges et lecture de ces charges a donc été complètement décrit pour une ligne de la matrice. Les différentes lignes reçoivent successivement chacune une impulsion de lecture suivie d'une impulsion de remise à niveau, et ces impulsions sont décalées dans le temps d'une ligne à l'autre pour qu'il n'y ait pas simultanément deux lignes adressées en lecture/remise à niveau.

Les intégrateurs du circuit de lecture CL doivent être court-circuités en dehors de l'impulsion de lecture (et particulièrement pendant les impulsions de remise à niveau) pour ne pas intégrer d'autres charges que les charges correspondant effectivement à une mesure de l'éclairement, c'est-à-dire les charges évacuées pendant l'impulsion de lecture. Par conséquent, il faut prévoir que l'impulsion de lecture d'une ligne est retardée non seulement par rapport à l'impulsion de lecture de la ligne précédente, mais aussi par rapport à l'impulsion de remise à niveau de la ligne précédente. Dans le cas de la figure 5 par exemple, le mieux est d'attendre l'instant t'0 pour commencer l'impulsion de lecture d'une ligne suivante.

## Revendications

1. Matrice de points photosensibles comportant un réseau de points photosensibles (Pij) agencés en lignes (au moins une ligne) et en colonnes (au moins une colonne), chaque point photosensible étant situé au carrefour d'une ligne et d'une colonne, caractérisée en ce que chaque point photosensible comprend un élément photosensible (DP) en série avec une diode de lecture (DL) entre un conducteur de ligne (Li) et un conducteur de colonne (Cj), la diode de lecture présentant un premier seuil de tension de mise en conduction dans le sens direct (Vsd), et un deuxième seuil de tension pour la mise en conduction dans le sens inverse (Vsi), la matrice comportant en outre, pour la lecture des charges accumulées au point de jonction (A) de l'élément photosensible et de la diode de lecture, un moyen pour appliquer sur le conducteur de ligne (Li):

– d'abord un niveau de tension de repos (Vp) sur le conducteur de ligne pendant une phase d'intégration de charges;

– puis une impulsion de tension d'un premier signe, dite impulsion de lecture;

– enfin une impulsion de tension du signe opposé, dite impulsion de remise à niveau, l'amplitude (VL1-VL2) de la différence entre les niveaux de tension de l'impulsion de lecture et de l'impulsion de remise à niveau étant supérieure en valeur absolue à l'écart entre les seuils de mise en conduction directe et inverse de la diode de lecture.

2. Matrice selon la revendication 1, caractérisée en ce que l'amplitude de la différence entre le niveau de tension de repos (Vp) et le niveau de tension de l'impulsion de remise à niveau (VL2) est voisine de l'écart entre les seuils de tension de mise en conduction directe (Vsd) et inverse (Vsi) de la diode de lecture.

3. Matrice selon la revendication 2, caractérisée en ce que l'amplitude de la différence entre le niveau de tension de repos (Vp) et le niveau de tension de l'impulsion de remise à niveau (VL2) est sensiblement égale à l'écart entre les seuils de tension de mise en conduction directe (Vsd) et inverse (Vsi) de la diode de lecture.

4. Matrice selon la revendication 2, caractérisée en ce que l'amplitude de la différence entre le niveau de tension de repos (Vp) et le niveau de tension de l'impulsion de remise à niveau (VL2) est légèrement inférieure à l'écart entre les seuils de tension de mise en conduction directe (Vsd) et inverse (Vsi) de la diode de lecture.

5. Matrice selon la revendication 2, caractérisée en ce que l'amplitude de la différence entre le niveau de tension de repos (Vp) et le niveau de tension de l'impulsion de remise à niveau (VL2) est légèrement supérieure à l'écart entre les seuils de tension de mise en conduction directe (Vsd) et inverse (Vsi) de la diode de lecture.

6. Matrice selon l'une des revendications précédentes, caractérisée en ce que le seuil de tension de mise en conduction inverse de la diode de lecture est inférieur à la tension de repos.

7. Matrice selon l'une des revendications 1 à 5, caractérisée en ce que le seuil de tension de mise en conduction inverse de la diode de lecture est supérieur à la tension de repos.

8. Matrice selon l'une des revendications précédentes, caractérisée en ce que la diode de lecture est réalisée sous forme d'un transistor à base ouverte de type NIPIN ou PINIP, c'est-à-dire une structure à deux électrodes et à cinq couches semiconductrices superposées qui sont respectivement une couche dopée de type N (ou inversement P), une couche intrinsèque relativement épaisse, une couche très mince de type P (ou inversement N), une couche très mince intrinsèque, et enfin une couche dopée de type N (ou inversement P).

9. Matrice selon l'une des revendications précédentes, caractérisée en ce que, en vue d'une application en radiologie, elle comporte un scintillateur pour convertir un rayonnement X (ou gamma, ou neutronique, etc.) en rayonnemnt lumineux dans la bande de longueurs d'onde auxquelles les points photosensibles sont sensibles.

10. Matrice selon l'une des revendications précédentes, caractérisée en ce que les points photosensibles sont constitués par superposition de couches de silicium amorphe.

**Patentansprüche**

1. Matrix von lichtempfindlichen Punkten, mit einem Gitter von lichtempfindlichen Punkten (Pij), die in Zeilen (wenigstens eine Zeile) und Spalten (wenigstens eine Spalte) angeordnet sind, wobei sich jeder lichtempfindliche Punkt auf der Kreuzung einer Zeile und einer Spalte befindet, dadurch gekennzeichnet, daß jeder lichtempfindliche Punkt ein lichtempfindliches Element (DP) aufweist, das zwischen einem Zeilenleiter (Li) und einem Spaltenleiter (Cj) mit einer Lesediode (DL) in Reihe geschaltet ist, wobei die Lesediode einen ersten Spannungsschwellenwert für den Durchlaß in direkter Richtung (Vsd) und einen zweiten Spannungsschwellenwert für den Durchlaß in entgegengesetzter Richtung (Vsi) aufweist, wobei die Matrix außerdem zum Lesen der im Verbindungspunkt (A) des lichtempfindlichen Elementes und der Lesediode akkumulierten Ladungen ein Mittel umfaßt, um an den Zeilenleiter (Li):
 – zuerst während einer Phase der Integration der Ladungen einen Ruhespannungspegel (Vp) für den Zeilenleiter;
 – dann einen Spannungsimpuls mit einem ersten Vorzeichen, einen sogenannten Leseimpuls;
 – und schließlich einen Spannungsimpuls mit entgegengesetztem Vorzeichen, einen sogenannten Pegelrückstellimpuls, anzulegen, wobei die Amplitude (VL1 - VL2) der Differenz zwischen den Spannungspegeln des Leseimpulses und des Pegelrückstellimpulses betragsmäßig größer als der Abstand zwischen den Schwellenwerten für den Durchlaß in direkter und entgegengesetzter Richtung der Lesediode ist.

2. Matrix gemäß Anspruch 1, dadurch gekennzeichnet, daß die Amplitude der Differenz zwischen dem Ruhespannungspegel (Vp) und dem Spannungspegel des Pegelrückstellimpulses (VL2) in der Nähe des Abstandes zwischen den Spannungsschwellenwerten für den Durchlaß in direkter (Vsd) und entgegengesetzter (Vsi) Richtung der Lesediode liegt.

3. Matrix gemäß Anspruch 2, dadurch gekennzeichnet, daß die Amplitude der Differenz zwischen dem Ruhespannungspegel (Vp) und dem Spannungspegel des Pegelrückstellimpulses (VL2) im wesentlichen gleich dem Abstand zwischen den Spannungsschwellenwerten für den Durchlaß in direkter (Vsd) und entgegengesetzter (Vsi) Richtung der Lesediode ist.

4. Matrix gemäß Anspruch 2, dadurch gekennzeichnet, daß die Amplitude der Differenz zwischen dem Ruhespannungspegel (Vp) und dem Spannungspegel des Pegelrückstellimpulses (VL2) etwas geringer als der Abstand zwischen den Spannungsschwellenwerten für den Durchlaß in direkter (Vsd) und entgegengesetzter (Vsi) Richtung der Lesediode ist.

5. Matrix gemäß Anspruch 2, dadurch gekennzeichnet, daß die Amplitude der Differenz zwischen dem Ruhespannungspegel (Vp) und dem Spannungspegel des Pegelrückstellimpulses (VL2) etwas größer als der Abstand zwischen den Spannungsschwellenwerten für den Durchlaß in direkter (Vsd) und entgegengesetzter (Vsi) Richtung der Lesediode ist.

6. Matrix gemäß einem der vorangehenden Ansprüche, dadurch gekennzeichnet, daß der Spannungschwellenwert der Lesediode für den Durchlaß in entgegengesetzter Richtung kleiner als die Ruhespannung ist.

7. Matrix gemäß einem der Ansprüche 1 bis 5, dadurch gekennzeichnet, daß der Spannungsschwellenwert der Lesediode für den Durchlaß in entgegengesetzter Richtung größer als die Ruhespannung ist.

8. Matrix gemäß einem der vorangehenden Ansprüche, dadurch gekennzeichnet, daß die Lesediode in Form eines Transistors mit offener Basis vom NIPIN- oder PINIP-Typ, d.h. mit einer Struktur aus zwei Elektroden und fünf übereinanderliegenden Halbleiterschichten verwirklicht ist, wobei die fünf Schichten durch eine N- (oder umgekehrt P-) dotierte Schicht, eine verhältnismäßig dicke Eigenleitungsschicht, eine sehr dünne P- (oder umgekehrt N-) Schicht, eine sehr dünne Eigenleitungsschicht und schließlich eine N- (oder umgekehrt P-) dotierte Schicht gegeben sind.

9. Matrix gemäß einem der vorangehenden Ansprüche, dadurch gekennzeichnet, daß sie für eine radiologische Anwendung einen Scintillator umfaßt, um Röntgenstrahlung (oder Gammastrahlung oder Neutronenstrahlung usw.) in Lichtstrahlung eines Wellenlängenbandes umzuwandeln, in dem die lichtempfindlichen Punkte ansprechen.

10. Matrix gemäß einem der vorangehenden Anpsrüche, dadurch gekennzeichnet, daß die lichtempfindlichen Punkte durch Überlagerung von Schichten aus amorphem Silizium gebildet sind.

## Claims

1. A matrix of photosensitive dots comprising a grid of photosensitive dots (Pij) arranged in lines (at least one thereof) and columns (at least one thereof), each photosensitive dot being situated at the intersection of a line and a column, characterized in that each photosensitive dot comprises a photosensitive element (DP) in series with a read diode (DL) between a line conductor (Li) and a column conductor (Cj), said read diode presenting a first voltage threshold for turning it on in the forward direction (Vsd) and a second voltage threshold for turning it on in the reverse direction (Vs1), said matrix furthermore comprising, for reading the charges accumulated at the junction dot (A) of the photosensitive element and of the read diode, a means for the application to the line conductor (Li) of the following:

– firstly a inactive condition voltage level (Vp) to the line conductor during a charge integration phase,

– then a voltage pulse with a first prefix sign as a read pulse, and

– lastly a voltage pulse with the opposite prefix sign as a level reset pulse, the absolute value of the amplitude (VL1-VL2) of the difference between the two levels of the voltage of the read pulse and of the level reset pulse being greater than the offset between the thresholds for turning on the read diode in the forward direction and the reverse direction.

2. The matrix as claimed in claim 1, characterized in that the amplitude of the difference between the inactive condition voltage (Vp) and the level of the pulse for reset to the level (VL2) is near the offset between the voltage thresholds for the turning on in the forward direction (Vsd) and the reverse direction (Vs1) of the read diode.

3. The matrix as claimed in claim 2, characterized in that the amplitude of the difference between the inactive condition voltage (Vp) and the level of the pulse for reset to the level (VL2) is substantially equal to the offset between the thresholds of the voltages for turning on the read diode in the forward direction (Vsd) and the reverse direction (Vs1).

4. The matrix as claimed in claim 2, characterized in that the amplitude of the difference between the inactive condition voltage (Vp) and the level of the pulse for reset to the level (VL2) is slightly less than the offset between the thresholds of the voltages for turning on the read diode in the forward direction (Vsd) and the reverse direction (Vs1).

5. The matrix as claimed in claim 2, characterized in that the amplitude of the difference between the inactive condition voltage (Vp) and the level of the pulse for reset to the level (VL2) is slightly greater than the offset between the thresholds of the voltages for turning on the read diode in the forward direction (Vsd) and the reverse direction (Vs1).

6. The matrix as claimed in any one of the preceding claims, characterized in that the voltage threshold for turning on the read diode in the reverse direction is less than the inactive condition voltage.

7. The matrix as claimed in any one of the preceding claims 1 through 5, characterized in that the voltage threshold for turning on the read diode in the reverse direction is greater than the inactive condition voltage.

8. The matrix as claimed in any one of the preceding claims, characterized in that the read diode is in the form of an open base transistor of the NIPIN or PINIP type, that is to say a structure with two electrodes with five superposed semiconductor layers which are respectively an N (or inversely P) doped layer, a relatively thick intrinsic layer, a very thin P (or inversely N) doped layer, and lastly an N (or inversely P) doped layer.

9. The matrix as claimed in any one of the preceding claims, characterized in that for the purpose of the application in radiology it comprises a scintillator in order to convert x-rays (or gamma rays or neutrons) into light in the band of wave lengths in which the said photosensitive dots respond.

10. The matrix as claimed in any one of the preceding claims, characterized in that the photosensitive dots are constituted by the superposition of layers of amorphous silicon.

EP 0 331 546 B1

FIG.1

11

FIG.2

FIG.3

FIG. 4a

FIG. 4b

FIG.5a

FIG.5b